# EUROPÄISCHE PATENTSCHRIFT

(11) **EP 2 502 876 B1**
(45) Veröffentlichungstag und Bekanntmachung des Hinweises auf die Patenterteilung: **19.11.2014**
(21) Anmeldenummer: 11401049.9
(22) Anmeldetag: 24.03.2011
(51) Int. Cl.: B81B 7/00, G01Q 20/04

(54) **Mikromechanisches Bauelement mit Federbalken und integriertem elektrischen Funktionselement**
Micromechanical device with a cantilever and an integrated electrical device
Composant micromécanique doté d'une poutre en porte à faux et d'un élément électrique intégré

(43) Veröffentlichungstag der Anmeldung: 26.09.2012
(73) Patentinhaber: NanoWorld AG, 2007 Neuchâtel (CH)
(72) Erfinder: Richter, Christoph, 91301, Forchheim (DE); Sulzbach, Thomas, 91085, Weisendorf (DE); Engl, Wolfgang, 91054, Erlangen (DE)
(74) Vertreter: Klocke, Peter

(56) Entgegenhaltungen:
- EP-A1- 0 516 418
- WO-A2-2004/075204
- US-A1- 2009 007 645

## Beschreibung

Die Erfindung betrifft ein mikromechanisches Bauelement, bestehend aus einem Halteelement und mindestens einem Federbalken, mit mindestens einem, in den Federbalken integrierten und auf einer ersten Flachseite des Federbalkens angeordneten elektrischen Funktionselement sowie mit mindestens zwei elektrischen Zuleitungen zu dem Funktionselement, die als Leiterbahnen an dem Federbalken ausgebildet sind.

Beispiele von dieser Art Bauelemente wurden in den Dokumenten WO 2004/075204, US 2009/0007645 und EP 0 516 418 A1 veröffentlicht.

Derartige mikromechanische Bauelemente werden beispielsweise bei der Rastersondenmikroskopie verwendet. Die Rastersondenmikroskopie (Scanning Probe Microscopy - SPM) hat sich zu einer etablierten Oberflächenanalysetechnik entwickelt, die unter anderem eine Abbildung von Oberflächentopographien mit einer Auflösung von wenigen Nanometern oder sogar bis in den atomaren Bereich hinein erlaubt. Ein wesentliches Kernelement dieser Technik ist die Abtastsonde, die einen mikromechanischen Federbalken mit integrierter Tastspitze enthält. Die Beschaffenheit und Qualität der Sonden trägt maßgeblich zur erzielbaren Auflösung der Oberflächenanalyse bei. Für die Herstellung der Sonden haben sich unterschiedliche Verfahren etabliert, die entweder auf der Ätzung von einkristallinem Silizium oder auf dünnen Schichten bevorzugt aus Silizium-Nitrid basieren.

Ein wesentlicher Nachteil der Rastersondenmikroskopie insgesamt ist die geringe Geschwindigkeit der Analyse, da die Sonde Punkt für Punkt über die Oberfläche gerastert wird. Die Geschwindigkeit der Rasterung ist hierbei einerseits durch den Rastermechanismus selbst aber auch durch die Resonanzfrequenz des Federbalkens der Sonde begrenzt. Aktuelle Entwicklungen auf dem Gebiet der Rastersondenmikroskopie adressieren diesen Umstand durch die Entwicklung neuartiger Systeme und Sonden, die mit deutlich höherer Geschwindigkeit arbeiten.

Um bei den Sonden für solche schnellen Rastersondenmikroskope die notwendige Erhöhung der Resonanzfrequenz zu erzielen, ohne gleichzeitig die Steifigkeit des Federbalkens zu verändern, muss der Federbalken in allen Dimensionen deutlich verkleinert werden. Typischerweise ist die Länge dieser hochfrequenten Federbalken unter 20 µm, ihre Breite unter 5 µm und ihre Dicke deutlich unter 1 µm und damit zumindest in Länge und Dicke etwa um einen Faktor 10 kleiner als zurzeit übliche Federbalken von SPM-Sonden.

Diese Dimensionen des Federbalkens stellen deutlich erhöhte Ansprüche an das Rastersondenmikroskop. Die Auslenkung des Federbalkens wird üblicherweise über das sogenannte Lichtzeigerprinzip realisiert, bei dem ein Laserstrahl auf die Rückseite, d. h. der Messprobe abgewandte Seite fokussiert wird. Die Bewegung des reflektierten Laserstrahls aufgrund einer Biegung des mikromechanischen Federbalkens wird in einer größeren Entfernung, üblicherweise von mehreren Zentimetern mit einer Segmentphotodiode gemessen. Dadurch ist die Detektion einer vertikalen Federbalkenbewegung durch Biegung mit einer Auflösung von deutlich besser als 1 nm möglich.

Im Fall der kleinen hochfrequenten Federbalken mit reduzierten Abmessungen muss die Fokussierung des Laserstahls auf einen entsprechend der Balkengröße reduzierten Durchmesser erfolgen. Insbesondere bei der üblicherweise bevorzugten Anordnung einer sich rasternd bewegenden SPM-Sonde über einer fixierten Messprobe ist die Realisierung eines Fokusdurchmessers von wenigen Mikrometern nur schwer erzielbar. Bei einer solchen Anordnung muss der Fokuspunkt mit der SPM-Sonde bewegt werden. Dafür ist die Mitführung mindestens einer optischen Komponente, in der Regel eine Linse notwendig. Dieses optische Element muss aber einerseits eine hohe optische Apertur besitzen, um einen hinreichend kleinen Fokusdurchmesser zu erzielen, andererseits muss das Element aber eine geringe Masse aufweisen, um schnell genug bewegt werden zu können.

Als nicht-optische Methode für die Detektion der Auslenkung vom mikromechanischen Federbalken hat sich die Integration eines piezoresistiven Dehnungssensors etabliert. Dafür wird in der Oberfläche eines Siliziumfederbalkens eine lokale Inversion der Dotierung erzeugt, die semi-isolierend gegenüber dem eigentlichen Balkenmaterial ist. Über geeignete Zuleitungen wird ein konstanter Strom eingeprägt und über die Änderung der Spannung die piezoresistive Änderung des Widerstands aufgrund der Dehnung der Federbalkenoberfläche bei der Auslenkung des Balkens gemessen.

Einer Skalierung dieses Konzeptes zu kleineren Abmessungen sind aber oft durch die vorhandenen Strukturierungsverfahren Grenzen gesetzt. Bei der kostengünstigen und weit verbreiteten Kontakt-Lithographie können typischerweise minimale Strukturgrößen von 1,5 bis 2 µm erreicht werden. Der Federbalken, in den der Dehnungssensor integriert werden soll, muss dementsprechend deutlich größer sein. Für Hin- und Rückleitung sowie den nötigen Mindestabstand zwischen den Leitungen und den Federbalkenrand werden 7,5 bis 10 µm benötigt, d. h. etwa die 5-fache Mindeststrukturbreite. Etwas kleinere Dimensionen sind möglich, wenn die Strukturierung des Dehnungssensors zusammen mit der Strukturierung des Federbalkens selbst erfolgt, der dann eine U- oder V-Form aufweisen muss. Eine Mindestbreite von etwa 6 µm ist aber auch in diesem bei Verwendung von Kontakt-Lithographie-Verfahren nicht zu unterschreiten. Die Federbalkengeometrie wird so deutlich oberhalb des mit gleichen Lithographieverfahren Machbaren begrenzt.

Ein weiterer Nachteil der bisherigen Sonden mit integrierten piezoresistiven Dehnungssensoren ist ihre aufwändige Integration in das Rastersondenmikroskop. Statt der üblichen Federklemmung passiver SPM-Sonden ist bei den Sonden mit piezoresistiven Dehnungssensoren eine elektrische Kontaktierung der Sonden notwendig. Dazu werden diese überlicherweise auf eine kleine Leiterbahnplatte geklebt und mit dieser über gebondete Drähte verbunden. Die hierfür notwendigen Montageschritte verteuern die Sonden in erheblichem Maße. Darüber hinaus ist eine aufwändige Modifikation des SPM-Messkopfes notwendig, um die montierten Sonden einbauen zu können.

Eine vergleichbare Problematik ergibt sich auch bei Sonden mit anderen integrierten Sensoren, wie beispielsweise Temperaturfühlern in Form von Thermokontakt-Sensoren, Thermowiderständen. Die elektrischen Zuleitungen erfordern auch hierbei eine erhebliche Modifikation des Messkopfes.

Ausgehend von dem vorstehend beschriebenen Stand der Technik liegt der Erfindung die Aufgabe zugrunde, eine Möglichkeit vorzuschlagen, die Breite des Federbalkens eines derartigen mikromechanischen Bauelementes deutlich zu reduzieren und damit hochfrequenter zu realisieren.

Diese Aufgabe wir erfindungsgemäß durch ein mikromechanisches Bauelement mit den Merkmalen des Patentanspruchs 1 gelöst. Weitere vorteilhafte Ausführungsformen sind den rückbezogenen Patentansprüchen zu entnehmen.

Das erfindungsgemäße mikromechanisches Bauelement besteht aus einem Halteelement und mindestens einem Federbalken, bei dem der Federbalken mindestens ein in den Federbalken integriertes und auf einer ersten Flachseite des Federbalkens angeordnetes elektrisches Funktionselement sowie mindestens zwei zu dem Funktionselement führende elektrische Zuleitungen aufweist. Mindestens eine erste Zuleitung ist auf der ersten Flachseite und mindestens eine zweite Zuleitung ist auf einer der ersten Flachseite gegenüber liegenden zweiten Flachseite des Federbalkens angeordnet. Die zweite Zuführung setzt sich auf der ersten Flachseite bis hin zu dem Funktionselement fort, wobei die zweite Zuleitung eine lokale elektrische Verbindung zwischen der ersten und der zweiten Flachseite des Federbalkens aufweist.

Vorzugsweise ist die lokale elektrische Verbindung über eine Schmalseite des Federbalkens und/oder über eine lokale Öffnung in dem Federbalken, die bevorzugt als eine lokale Leiterbahn realisiert ist. Dabei kann bei einer über eine lokale Öffnung hergestellte Verbindung die lokale Öffnung ganz oder teilweise mit elektrisch leitfähigem Material ausgekleidet und/oder gefüllt ist. Bei einer bevorzugten Ausführungsform der Erfindung bestehen die Zuleitungen auf den beiden Flachseiten aus unterschiedlichen leitfähigen Materialien, die an der lokalen elektrischen Verbindung in Kontakt sind.

Bei einer Ausführung des erfindungsgemäßen mikromechanischen Bauelements weist der Federbalken an seinem freien Ende eine Tastspitze aufweist, die vorzugsweise an der dem Haltelement abgewandten Flachsseite des Federbalkens angeordnet ist, wobei die lokale Öffnung an der Tastspitze und vorzugsweise im Apex der Tastspitze ausgebildet ist. Das elektrische Funktionselement ist vorzugsweise ebenfalls an der dem Haltelement abgewandten Flachsseite des Federbalkens angeordnet. Bei einer Variante der Erfindung besteht der Federbalken aus einem Halbleitermaterial. In diesem Fall ist es vorgesehen, die lokale elektrische Verbindung von der ersten Flachseite zur zweiten Flachseite durch eine lokale Inversion der Dotierung des Federbalkenmaterials zu realisieren. Außerdem können sich die elektrischen Zuleitungen zu dem Funktionselement nicht nur auf unterschiedlichen Flachseiten des Federbalkens sondern weiter auf unterschiedlichen Flachseiten des Halteelementes erstrecken.

Bei dem vorgeschlagenen mikromechanischen Bauelement kann der Federbalken eine Länge von weniger als 500 µm, eine Breite von weniger als 50 µm und eine Dicke von weniger als 10 µm, eine Länge von weniger als 50 µm, bei einer Breite von weniger als 5 µm und einer Dicke von weniger als 1 µm oder eine Länge von weniger als 10 µm, eine Breite von weniger als 3 µm und eine Dicke von weniger als 0,5 µm besitzen.

Als integriertes Funktionselement kann bei dem vorgeschlagenen mikromechanischen Bauelement ein piezoresistiver Dehnungssensor, ein Aktuator zur Verbiegung des Federbalkens, ein piezoelektrischer Wandler, ein Thermosensor, ein Photodetektor, ein Magnetwiderstandssensor oder ein Gas-Sensor als Funktionselement verwendet werden. Dabei ist das mikromechanisches Bauelement insbesondere auch als SPM-Sonde einsetzbar. Prinzipiell können die oben angeführten Beispiele integrierter elektrischer Funktionselemente erfindungsgemäß auch kombiniert werden. Durch Integration von Aktuator und Sensor in den Federbalken wird ein autarkes Mikrosystem möglich, dass eine Parallelisierung der Messung mit Federbalken ohne Einschränkung möglich macht.

Nachfolgend wird die Erfindung anhand mehrerer in der Zeichnung schematisch dargestellter Ausführungsbeispielen nochmals ausführlich erläutert. Weitere Merkmale der Erfindung ergeben sich aus der folgenden Beschreibung des Ausführungsbeispiels der Erfindung in Verbindung mit den Ansprüchen und der beigefügten Zeichnung. Die einzelnen Merkmale der Erfindung können für sich allein oder zu mehreren bei unterschiedlichen Ausführungsformen der Erfindung verwirklicht sein. Es zeigen:
- Figur 1: ein erstes erfindungsgemäßes mikromechanisches Bauelement ohne Tastspitze und einer am Rand ausgebildeten lokalen elektrischen Verbindung zwischen den Flachseiten des Federbalkens, in perspektivischer Ansicht;
- Figur 2: das mikromechanische Bauelement aus Figur 1, in einer Längsschnittdarstellung;
- Figur 3: ein zweites erfindungsgemäßes mikromechanisches Bauelement ohne Tastspitze und mit einer innerhalb des Federbalkens realisierte lokale elektrische Verbindung zwischen den Flachseiten des Federbalkens, in einer Längsschnittdarstellung;
- Figur 4: ein drittes erfindungsgemäßes mikromechanisches Bauelement ähnlich dem mikromechanischen Bauelement aus Figur 3, jedoch mit Tastspitze, in einer Längsschnittdarstellung;
- Figur 5: ein viertes erfindungsgemäßes mikromechanisches Bauelement als Variante des mikromechanischen Bauelements aus Figur 4, in einer Längsschnittdarstellung
- Figur 6: ein fünftes erfindungsgemäßes mikromechanisches Bauelement ähnlich dem mikromechanischen Bauelement aus Figur 5, mit einem an einer anderen Stelle des Federbalkens angeordneten Funktionselement, in einer Längsschnittdarstellung;
- Figur 7: ein sechstes mikromechanisches Bauelement mit Tastspitze, bei dem die lokale elektrische Verbindung im Apex der Tastspitze angeordnet ist, in einer Längsschnittdarstellung; und
- Figur 8: das mikromechanische Bauelement aus Figur 2, verbunden mit einem SPM-Messkopf, in einer Längsschnittdarstellung.

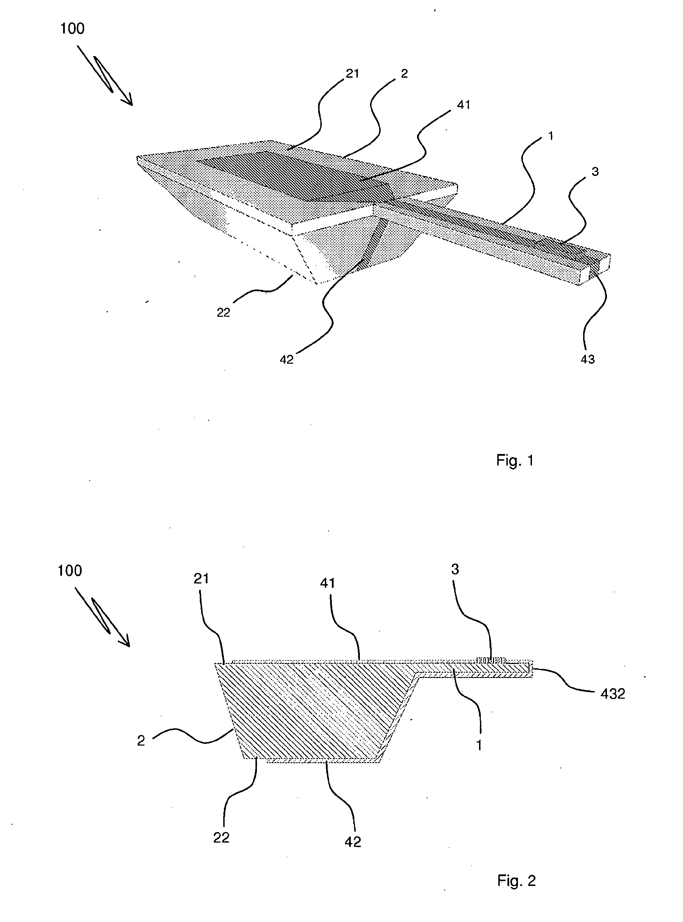

Die Figuren 1 bis 7 zeigen jeweils ein erfindungsgemäßes mikromechanisches Bauelement 100, mit einem mikromechanischen Federbalken 1, der an einen Halteelement 2 befestigt ist und mindestens ein integriertes elektrisches Funktionselement 3 besitzt. Erfindungsgemäß wird mindestens eine Zuleitung 41 zu dem in den mikromechanischen Federbalken 1 integrierten Funktionselement 3 über eine erste Flachseite 21 des Haltelementes 2, an dem der Federbalken 1 befestigt ist, und über die entsprechende erste Flachseite 21 des Federbalkens 1 realisiert und mindestens eine weitere zweite Zuleitung 42 (Rückleitung) über die gegenüber liegende zweite Flachseite 22 des Haltelementes 2 sowie des Federbalkens 1. Dabei ist das elektrische Funktionselement 3 an der dem Haltelement 2 abgewandten Flachsseite 21 des Federbalkens 1 angeordnet. Zumindest im Sonderfall zweier Zuleitungen 41, 42 kann dadurch das mikromechanische Bauelement 100 mittels einfach zu realisierenden mechanischen Kontakten von den beiden gegenüberliegenden Seiten des Haltelementes 2 elektrisch kontaktiert werden.

Darüber hinaus ist eine deutliche Reduzierung der Abmessungen des mikromechanischen Federbalkens 1 mit integriertem elektrischem Funktionselement 3 möglich, da Hin- und Rückleitung nicht auf der gleichen Flachseite 21 oder 22 des Federbalkens 1 integriert werden müssen, sondern auf gegenüberliegenden Oberflächen der Flachseiten 21, 22 des Federbalkens 1. Dadurch kann die Größe des Federbalkens 1 mindestens um einen Faktor 2 verkleinert werden.

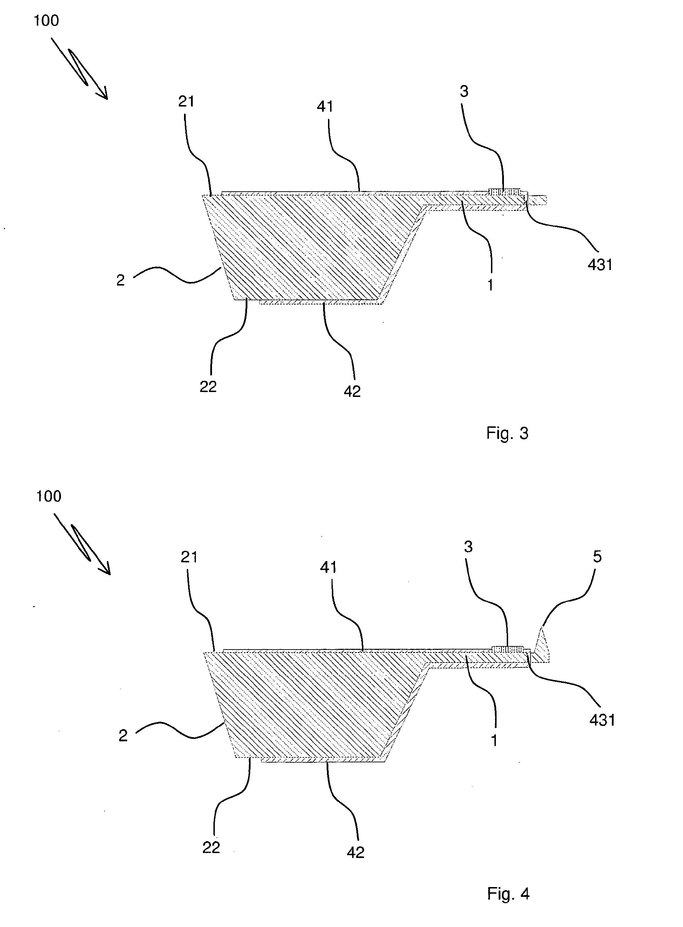

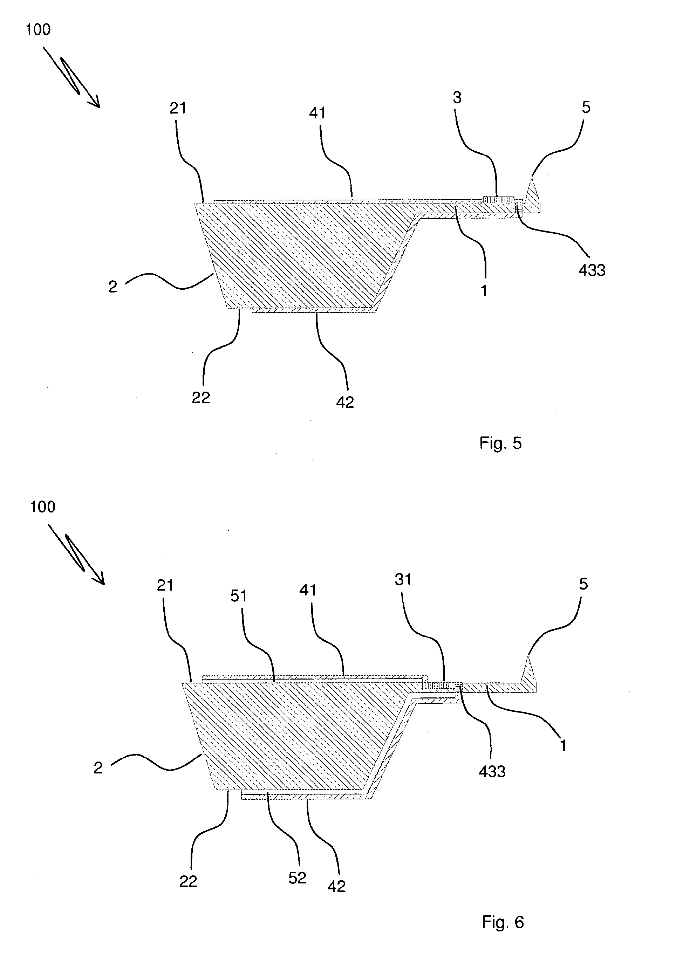

Eine lokale elektrische Verbindung zwischen einer oder mehreren Zuleitungen 41 (Hinleitungen) auf einer Flachseite 21 des Halteelementes 2 sowie des Federbalkens 1 und der bzw. den entsprechenden Zuleitungen 42 (Rückleitungen) auf der gegenüberliegenden Flachseite 22 wird erfindungsgemäß durch eine oder mehrere lokale vertikale elektrische Verbindungen 43, 431, 432, 433 ausgeführt. Diese sind bei den Ausführungsbeispielen der Figuren 1, 2 als leitfähige Bahnen 43, 432 über den Rand und die Schmalseite des Federbalkens 1 hinweg und bei den Ausführungsbeispielen der Figuren 3, 4, 5, 6 als Durchkontaktierungen 431, 433 im Federbalken 1 ausgebildet. Die Durchkontaktierungen 431, 433 können mittels durch den Federbalken 1 hindurch geätzte mit leitfähigem Material versehene Öffnungen 431 (Figur 3, 4) realisiert werden oder mittels lokalen Dotierungen 433 durch den Federbalken 1 hindurch (Figur 5, 6). Bei den in den Figuren 4 - 7 dargestellten Ausführungsbeispielen ist die Tastspitze 5 an der dem Haltelement 2 abgewandten Flachseite 21 des Federbalkens 1 angeordnet ist

Das in der Figur 6 dargestellte Ausführungsbeispiel der Erfindung zeigt eine SPM-Sonde 100 mit integrierter piezoresistiver Auslenkungsdetektion. Das in den Federbalken 1 integrierte Funktionselement 3 ist ein piezoresistiver Widerstand 31, mit dessen Hilfe die Dehnung der Federbalkenoberfläche und damit dessen Auslenkung in ein elektrisches Signal umgesetzt wird. Erfindungsgemäß erfolgt die Zuleitung 41 über die Flachseite 21 der SPM-Sonde 100, in deren Oberfläche auch der piezoresistive Widerstand 31 realisiert ist. Zwischen der Zuleitung 41 an der Flachseite 21 sowie zwischen der Zuleitung 42 and der Flachseite 22 und dem Halteelement 2 bzw. dem Federbalken 1 ist jeweils eine Isolierschicht 51 bzw. 52 angeordnet. Die Durchführung 43 zur Federbalkenrückseite kann durch lokale Inversion mittels Dotierung erzeugt werden. Bei ausreichend hoher Dotierungskonzentration und -tiefe kann eine niederohmige Verbindung 433 zur Rückseite des Federbalkens 1 erzeugt werden. Gleichzeitig ist über eine solche, mit hoher Konzentration dotierte Region eine elektrische Kontaktierung des üblicherweise hochohmigen, schwach dotierten, piezoresistiven Widerstandes 31 mit einer metallischen Leiterbahn 42 möglich, die erfindungsgemäß auf der gegenüber liegenden Seite angeordnet ist. Die für eine SPM-Sonde 100 notwendige Tastspitze 5 kann entweder vorab geätzt oder nachträglich mittels elektronenstahlinduzierter Abscheidung aufgewachsen werden. Die Isolierschichten 51, 52 ist nicht auf das in der Figur 6 abgebildete Ausführungsbeispiel beschränkt.

Durch diese Konfiguration wird es möglich, die Abmessungen des Federbalkens 1 mit integrierter Auslenkungsdetektion auf wenige Mikrometer Länge und Breite sowie einige hundert Nanometer Dicke zu begrenzen, sodass Resonanzfrequenzen von über 10 MHz bei einer, für dynamisches AFM üblichen Federkonstanten von etwa 40 N/m erzielt werden können. Bei geänderter Federbalkengeometrie sind aber auch Resonanzfrequenzen von deutlich über 1 MHz bei Federkonstanten von 0,2 N/m möglich, wie sie für Kontaktmodus-AFM-Messungen bei hoher Geschwindigkeit benötigt werden. Bei den nach dem Stand der Technik auf einer Seite der Sonde integrierten Zuleitungen sind aufgrund der größeren minimalen Federbalkenabmessungen bei gleicher Federkonstante nur deutlich geringere Resonanzfrequenzen erzielbar.

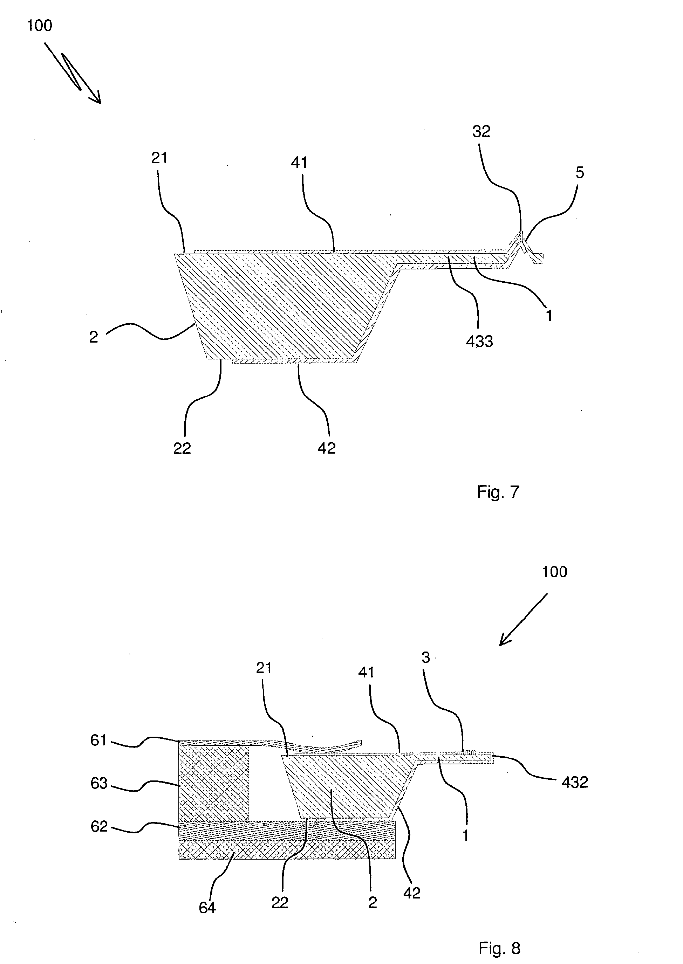

Als ein weiteres Ausführungsbeispiel zeigt die Figur 7 eine SPM-Sonde 100 mit integriertem Thermokontakt-Temperaturfühler 32. Diese Sonde 100 besteht aus einem mikromechanischen Federbalken 1 mit abgeformter Tastspitze 5. Im Apex der Tastspitze 5 befindet sich eine durchgehende Öffnung, die z.B. mittels Lithographie und Ätzverfahren oder mittels Abtrag durch fokussierte lonenstrahlen erzeugt werden kann. Die beiden gegenüberliegenden Flachseiten 21, 22 der Sonde 100 und damit auch des Federbalkens 1 sind mit unterschiedlichen Metallen als Zuleitungen 41, 42 beschichtet, die z.B. mittels Elektronenstrahlverdampfen aufgebracht werden können. Über die Öffnung in der Tastspitze 5 sind die beiden Metalle lokal miteinander verbunden und bilden einen Thermokontakt 32. Bevorzugt sind dabei Metall-Paare mit hohem Seebeck-Koeffizient, die eine optimale Temperaturempfindlichkeit gewährleisten. Um parasitäre Kurzschlüsse über den Sonden- oder Federbalkenränder zu vermeiden, können eine oder beide Metallschichten zusätzlich lithographisch strukturiert werden. Auf der dem Halteelement (2) abgewandten Flachseite (21) ist ein nicht dargestelltes weiteres Funktionselement anordenbar. Die erfindungsgemäßen Sonden lassen sich ebenfalls, wie oben beschrieben, mit einem nur leicht modifizierten Sondenhalter kontaktieren und benötigen keinen fest montierten Träger.

Über dieses Beispiel hinaus können in die Tastspitze 5 von SPM-Sonden 100 auch andere Funktionselemente, wie lokale Feldemitter, GMR-Sensoren oder Photodioden integriert werden.

Anstelle des Auslenkungssensors 31 kann auch ein elektromechanischer Aktuator 3 in den Federbalken 1 integriert und erfindungsgemäß von zwei gegenüber liegenden Flachseiten 21, 22 des Bauelementes 100 kontaktiert werden. Als Aktuatorelemente kommen piezoelektrische Systeme z. B. aus PZT, ZnO oder AIN-Schichten in Frage. Prinzipiell können diese piezoelektrischen Systeme aber auch umgekehrt zur Transformation von mechanischer Energie in elektrische Energie verwendet werden. Eine solche Anwendung ist explizit mit eingeschlossen.

Ein weiteres Anwendungsbeispiel der Erfindung sind kombinierte elektrische und mechanische Gas-Sensoren. Polymer- oder Festkörperbasierte Gas-Sensoren lassen sich erfindungsgemäß leichter in mikromechanische Federbalken 3 integrieren. Dadurch wird eine Kombination aus direkter elektrischer Messung und Charakterisierung über Änderung der mechanischen Eigenschaften des Federbalkens (Verbiegung aufgrund von induzierten Oberflächenspannungen, Änderung der Resonanzfrequenz aufgrund geänderter Masse, usw.) möglich.

Die Figur 8 zeigt die SPM-Sonde 100 der Figuren 1, 2 montiert an einem SPM-Messkopf, von dem nur die Befestigungseinrichtung für die Sonde 100 dargestellt ist. Die Kontaktierung kann bei allen Ausführungsformen der Erfindung in gleicher Weise erfolgen. Die elektrische Kontaktierung der erfindungsgemäßen SPM-Sonde 100 mit integriertem piezoresistiven Dehnungssensor 31 im SPM-Messkopf kann über Federkontakte 61 und 62, die mittels Isolatoren 63 und 64 elektrische voneinander bzw. vom restlichen Aufbau getrennt sind, erfolgen. Die übliche Konfiguration des Sondenhalters im SPM-Messkopf muss dafür nur geringfügig verändert werden. Nach Stand der Technik wird in einer üblichen Ausführung die Sonde 100 mit einer metallischen Feder gegen einen metallischen Träger gedrückt. Über diese beiden Elemente des Sonden-Halters können die Zu- und Hinleitung kontaktiert werden. Es muss lediglich eine elektrische Verbindung zwischen der Feder auf der einen Seite und des Trägers auf der anderen Seite mit der Kontrollelektronik des SPM-Systems realisiert werden. Eine solche Modifikation ist leicht umsetzbar. Eine feste Verbindung der SPM-Sonde 100 mit einem Träger und die damit verbundenen hohen Montagekosten für das Verbrauchsmaterial Sonde sind nicht notwendig, sodass sich für den Nutzer eine erhebliche Kostenersparnis ergibt.

## Patentansprüche

1. Mikromechanisches Bauelement (100), bestehend aus einem Halteelement (2) und mindestens einem Federbalken (1), mit mindestens einem, in den Federbalken (1) integrierten und auf einer ersten Flachseite (21) des Federbalkens (1) angeordneten elektrischen Funktionselement (3) sowie mit mindestens zwei elektrischen Zuleitungen (41, 42) zu dem Funktionselement (3), die als Leiterbahnen an dem Federbalken (1) ausgebildet sind, **dadurch gekennzeichnet, dass** mindestens eine erste Zuleitung (41) auf der ersten Flachseite (21) und mindestens eine zweite Zuleitung (42) auf einer der ersten Flachseite (21) gegenüber liegenden zweiten Flachseite (22) des Federbalkens (1) angeordnet ist, die sich auf der ersten Flachseite (21) bis hin zu dem Funktionselement (3) fortsetzt, wobei die zweite Zuleitung (42) eine lokale elektrische Verbindung (43, 431, 432) zwischen der ersten und der zweiten Flachseite (21, 22) aufweist.

2. Mikromechanisches Bauelement nach Anspruch 1, **dadurch gekennzeichnet, dass** die lokale elektrische Verbindung (43, 431, 432) über eine Schmalseite des Federbalkens (1) und/oder über eine lokale Öffnung im Federbalken (3) realisiert ist.

3. Mikromechanisches Bauelement nach Anspruch 2, **dadurch gekennzeichnet, dass** die lokale elektrische Verbindung (43, 431, 432) eine lokale Leiterbahn ist.

4. Mikromechanisches Bauelement nach Anspruch 2 oder 3, **dadurch gekennzeichnet, dass** die lokale Öffnung zumindest teilweise mit elektrisch leitfähigem Material gefüllt ist.

5. Mikromechanisches Bauelement nach einem der vorstehenden Ansprüche, **dadurch gekennzeichnet, dass** die Zuleitungen (41, 42) auf den beiden Flachseiten (21, 22) aus unterschiedlichen leitfähigen Materialien bestehen, die an der lokalen elektrischen Verbindung (43, 431, 432) in Kontakt sind.

6. Mikromechanisches Bauelement nach einem der vorstehenden Ansprüche, **dadurch gekennzeichnet, dass** der Federbalken (1) an seinem freien Ende eine Tastspitze (5) aufweist, die an der dem Haltelement (2) abgewandten Flachseite (21) des Federbalkens (1) angeordnet ist.

7. Mikromechanisches Bauelement nach Anspruch 6, **dadurch gekennzeichnet, dass** die lokale Öffnung an der Tastspitze (5) vorzugsweise im Apex der Tastspitze (5) ausgebildet ist.

8. Mikromechanisches Bauelement nach einem der vorstehenden Ansprüche, **dadurch gekennzeichnet, dass** das elektrische Funktionselement (3) an der dem Haltelement (2) abgewandten Flachsseite (21) des Federbalkens (1) angeordnet ist.

9. Mikromechanisches Bauelement nach einem der vorstehenden Ansprüche, **dadurch gekennzeichnet, dass** der Federbalken (1) aus einem Halbleitermaterial besteht.

10. Mikromechanisches Bauelement nach einem der vorstehenden Ansprüche, **dadurch gekennzeichnet, dass** die lokale elektrische Verbindung (43, 431, 432) von der ersten Flachseite (21) zur zweiten Flachseite (22) durch eine lokale Inversion der Dotierung des Federbalkenmaterials realisiert ist.

11. Mikromechanisches Bauelement nach einem der vorstehenden Ansprüche, **dadurch gekennzeichnet, dass** sich die elektrischen Zuleitungen (41, 42) zu dem Funktionselement (3) auf unterschiedlichen Flachseiten (21, 22) des Federbalkens (1) und des Halteelementes (2) erstrecken.

12. Mikromechanisches Bauelement nach einem der vorstehenden Ansprüche, **dadurch gekennzeichnet, dass** der Federbalken (1) eine Länge von weniger als 500 µm, eine Breite von weniger als 50 µm und eine Dicke von weniger als 10 µm oder eine Länge von weniger als 50 µm, eine Breite von weniger als 5 µm und eine Dicke von weniger als 1 µm oder eine Länge von weniger als 10 µm, eine Breite von weniger als 3 µm und eine Dicke von weniger als 0,5 µm besitzt.

13. Mikromechanisches Bauelement nach einem der vorstehenden Ansprüche, **dadurch gekennzeichnet, dass** das integrierte Funktionselement (3) ein piezoresistiver Dehnungssensor, ein Aktuator zur Verbiegung des Federbalkens (1), ein piezoelektrischer Wandler, ein Thermosensor, ein Photodetektor, ein Magnetwiderstandssensor oder ein Gas-Sensor ist.

14. Mikromechanisches Bauelement nach einem der vorstehenden Ansprüche, **dadurch gekennzeichnet, dass** das mikromechanische Bauelement (100) eine SPM-Sonde ist.

## Claims

1. Micromechanical component (100) consisting of a support element (2) and at least one cantilever (1), having at least one electrical functional element (3) integrated into the cantilever (1) and arranged on a first flat side (21) of the cantilever (1), as well as having at least two electrical supply lines (41, 42) to the functional element (3), which are formed as conductor paths on the cantilever (1), **characterised in that** at least one first supply line (41) is arranged on the first flat side (21) and at least one second supply line (42) is arranged on a second flat side (22) of the cantilever (1) lying opposite the first flat side (21), the second supply line (42) continuing to the functional element (3) on the first flat side (21), wherein the second supply line (42) has a local electrical connection (43, 431, 432) between the first and the second flat side (21, 22).

2. Micromechanical component according to claim 1, **characterised in that** the local electrical connection (43, 431, 432) is implemented via a narrow side of the cantilever (1) and/or via a local opening in the cantilever (3).

3. Micromechanical component according to claim 2, **characterised in that** the local electrical connection (43, 431, 432) is a local conductor path.

4. Micromechanical component according to claim 2 or 3, **characterised in that** the local opening is filled at least partially with electrically conductive material.

5. Micromechanical component according to one of the preceding claims, **characterised in that** the supply lines (41, 42) on the two flat sides (21, 22) consist of different conductive materials, which are in contact with the local electrical connection (43, 431, 432).

6. Micromechanical component according to one of the preceding claims, **characterised in that** the cantilever (1) has a measuring pin (5) on its free end, which is arranged on the flat side (21) of the cantilever (1) facing away from the support element (2).

7. Micromechanical component according to claim 6, **characterised in that** the local opening is formed on the measuring pin (5), preferably in the apex of the measuring pin (5).

8. Micromechanical component according to one of the preceding claims, **characterised in that** the electrical functional element (3) is arranged on the flat side (21) of the cantilever (1) facing away from the support element (2).

9. Micromechanical component according to one of the preceding claims, **characterised in that** the cantilever (1) consists of a semi-conductor material.

10. Micromechanical component according to one of the preceding claims, **characterised in that** the local electrical connection (43, 431, 432) from the first flat side (21) to the second flat side (22) is implemented by a local inversion of the doping of the cantilever material.

11. Micromechanical component according to one of the preceding claims, **characterised in that** the electrical supply lines (41, 42) to the functional element (3) extend on different flat sides (21, 22) of the cantilever (1) and of the support element (2).

12. Micromechanical component according to one of the preceding claims, **characterised in that** the cantilever (1) has a length of less than 500µm, a width of less than 50µm and a thickness of less than 10µm or a length of less than 50µm, a width of less than 5µm and a thickness of less than 1µm or a length of less than 10µm, a width of less than 3µm and a thickness of less than 0.5µm.

13. Micromechanical component according to one of the preceding claims, **characterised in that** the integrated functional element (3) is a piezoresistive strain sensor, an actuator for bending the cantilever (1), a piezoelectric converter, a thermosensor, a photo detector, a magneto-resistance sensor or a gas sensor.

14. Micromechanical component according to one of the preceding claims, **characterised in that** the micromechanical component (100) is an SPM probe.

## Revendications

1. Composant micromécanique (100), composé d'un élément de retenue (2) et d'au moins une poutre élastique (1), avec au moins un élément fonctionnel électrique (3) intégré dans la poutre élastique (1) et disposé sur une première face plate (21) de la poutre élastique (1) ainsi qu'avec au moins deux lignes d'alimentation électriques (41, 42) allant à l'élément fonctionnel (3), qui sont réalisées sous la forme de pistes conductrices sur la poutre élastique (1), **caractérisé en ce qu'**au moins une première ligne d'alimentation (41) est disposée sur la première face plate (21) et au moins une deuxième ligne d'alimentation (42) sur une deuxième face plate (22) de la poutre élastique (1), opposée à la première face plate (21), qui se prolonge sur la première face plate (21) jusqu'à l'élément fonctionnel (3), la deuxième ligne d'alimentation (42) présentant une liaison électrique locale (43, 431, 432) entre la première et la deuxième face plate (21, 22).

2. Composant micromécanique selon la revendication 1, **caractérisé en ce que** la liaison électrique locale (43, 431, 432) est réalisée via un petit côté de la poutre élastique (1) et/ou via une ouverture locale dans la poutre élastique (3).

3. Composant micromécanique selon la revendication 2, **caractérisé en ce que** la liaison électrique locale (43, 431, 432) est une piste conductrice locale.

4. Composant micromécanique selon la revendication 2 ou 3, **caractérisé en ce que** l'ouverture locale est au moins partiellement remplie de matériau électriquement conducteur.

5. Composant micromécanique selon l'une des revendications précédentes, **caractérisé en ce que** les lignes d'alimentation (41, 42) sur les deux faces plates (21, 22) sont composées de matériaux électriquement conducteurs différents qui sont en contact à la liaison électrique locale (43, 431, 432).

6. Composant micromécanique selon l'une des revendications précédentes, **caractérisé en ce que** la poutre élastique (1) présente à son extrémité libre une pointe de touche (5) qui est disposée sur la face plate (21) de la poutre élastique (1) qui est éloignée de l'élément de retenue (2).

7. Composant micromécanique selon la revendication 6, **caractérisé en ce que** l'ouverture locale à la pointe de touche (5) est de préférence réalisée au sommet de la pointe de touche (5).

8. Composant micromécanique selon l'une des revendications précédentes, **caractérisé en ce que** l'élément fonctionnel électrique (3) est disposé sur la face plate (21) de la poutre élastique (1) qui est éloignée de l'élément de retenue (2).

9. Composant micromécanique selon l'une des revendications précédentes, **caractérisé en ce que** la poutre élastique (1) est constituée d'un matériau semiconducteur.

10. Composant micromécanique selon l'une des revendications précédentes, **caractérisé en ce que** la liaison électrique locale (43, 431, 432) de la première face plate (21) à la deuxième face plate (22) est réalisée par une inversion locale du dopage du matériau de la poutre élastique.

11. Composant micromécanique selon l'une des revendications précédentes, **caractérisé en ce que** les lignes d'alimentation électriques (41, 42) allant à l'élément fonctionnel (3) s'étendent sur des faces plates différentes (21, 22) de la poutre élastique (1) et de l'élément de retenue (2).

12. Composant micromécanique selon l'une des revendications précédentes, **caractérisé en ce que** la poutre élastique (1) possède une longueur de moins de 500 µm, une largeur de moins de 50 µm et une épaisseur de moins de 10 µm ou une longueur de moins de 50 µm, une largeur de moins de 5 µm et une épaisseur de moins de 1 µm ou une longueur de moins de 10 µm, une largeur de moins de 3 µm et une épaisseur de moins de 0,5 µm.

13. Composant micromécanique selon l'une des revendications précédentes, **caractérisé en ce que** l'élément fonctionnel (3) intégré est un capteur d'allongement piézorésistif, un actionneur de déformation de la poutre élastique (1), un convertisseur piézoélectrique, un capteur thermique, un photodétecteur, un capteur magnétorésistif ou un capteur de gaz.

14. Composant micromécanique selon l'une des revendications précédentes, **caractérisé en ce que** le composant micromécanique (100) est une sonde SPM.
